(19) Europäisches Patentamt

European Patent Office

Office européen des brevets

(11) **EP 1 049 099 A2**

(12) **EUROPÄISCHE PATENTANMELDUNG**

(43) Veröffentlichungstag:
**02.11.2000 Patentblatt 2000/44**

(51) Int. Cl.⁷: $G11C\ 5/14$, $G11C\ 7/00$

(21) Anmeldenummer: **00106821.2**

(22) Anmeldetag: **30.03.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **31.03.1999 DE 19914781**

(71) Anmelder:
**SIEMENS AKTIENGESELLSCHAFT
80333 München (DE)**

(72) Erfinder:
• **Pramanik, Robin
  76135 Karlsruhe (DE)**
• **Sass, Frank
  76187 Karlsruhe (DE)**

(54) **Elektronisches Gerät, insbesondere Feldgerät**

(57) Ein elektronisches Gerät weist eine datenverarbeitende Gerätesteuerung (1), einen nichtflüchtigen Speicher (2) und eine Stromversorgungseinrichtung (3) auf. Sowohl die Gerätesteuerung (1) als auch der nichtflüchtige Speicher (2) weisen zwischen ihren Versorgungsspannungsanschlüssen (6, 7; 8, 9) jeweils einen eigenen Stützkondensator ($C_1$, $C_2$) auf, wobei der Ladestrom in den Stützkondensator ($C_2$) des nichtflüchtigen Speichers (2) durch einen Widerstand ($R_{S1}$) begrenzt ist und die Entladung dieses Stützkondensators ($C_2$) in den der Gerätesteuerung (1) zugeordneten Stützkondensator ($C_1$) durch eine Diode (D) verhindert wird. Durch diese Entkopplung der Stützkondensatoren ($C_1$, $C_2$) kann die Stromversorgung der Gerätesteuerung (1) und des nichtflüchtigen Speichers (2) in zwei jeweils für sich eigensicheren Stromkreisen erfolgen.

FIG. 1

**Beschreibung**

Bei elektronischen Geräten, in deren Gerätesteuerung Daten verarbeitet werden, müssen häufig bestimmte Daten, z. B. Betriebsstundenzähler, für den Fall eines Einbruchs der Versorgungsspannung gesichert werden, damit sie beim Wiederanlauf des Geräts zur Verfügung stehen. Zur Datensicherung werden nichtflüchtige Speicher, wie z. B. Flash-EPROMs oder EEPROMs, verwendet. Die Hersteller solcher nichtflüchtiger Speicher garantieren eine minimale Anzahl von beispielsweise 100000 Speicherzyklen. Diese garantierte Anzahl gilt jedoch nur für Raumtemperatur und ist im erweiterten Temperaturbereich von z. B. -45 °C bis 85 °C um 80 bis 90 % zu reduzieren. Bei einem Betriebsstundenzähler mit einer Auflösung von 1 Std. und einer durch den Temperaturbereich von 100000 auf 20000 reduzierten garantierten Anzahl von Speicherzyklen ergibt sich eine Lebensdauer des nichtflüchtigen Speichers von nur zweieinhalb Jahren, wenn die Daten stündlich abgespeichert werden.

Bei dem in Anspruch 1 angegebenen erfindungsgemäßen elektrischen Gerät werden ausgewählte Daten zum Zwecke der Datensicherung nur dann gespeichert, wenn tatsächlich ein Versorgungsspannungseinbruch detektiert wurde, so daß der nichtflüchtige Speicher für die Datensicherung nur minimal beansprucht wird und daher z. B. in höherem Maße für routinemäßige Speichervorgänge verwendet werden kann. Die für den Speichervorgang erforderliche Energie bezieht der nichtflüchtige Speicher aus einem eigenen Stützkondensator, dessen Ladestrom durch einen Strombegrenzungswiderstand begrenzt ist, so daß die Stromversorgung der Gerätesteuerung während des Speichervorgangs nur in vernachlässigbarem Maße belastet wird. Dies ist insbesondere bei fremdgespeisten Feldgeräten von Bedeutung. Durch das elektrische Ventil wird verhindert, daß im Falle eines Versorgungsspannungseinbruchs der dem nichtflüchtigen Speicher zugeordnete Stützkondensator entladen wird.

Bei nichtflüchtigen Speichern in MOS-Technik sind in der Regel die Ein- und Ausgänge über interne Schutzdioden mit den Versorgungsspannungsanschlüssen verbunden. Um zu verhindern, daß von den Ein- und Ausgängen über die Schutzdioden ein zu großer Ladestrom in den Stützkondensator des nichtflüchtigen Speichers fließen kann, sind vorzugsweise Widerstände in der Datenleitung und gegebenenfalls weiteren Leitungen zwischen der Gerätesteuerung und dem nichtflüchtigen Speicher angeordnet.

Die Entkopplung der beiden Stützkondensatoren für die Gerätesteuerung und den nichtflüchtigen Speicher über das elektrische Ventil, den Strombegrenzungswiderstand und gegebenenfalls die Widerstände in der Datenleitung und weiteren Leitungen ermöglicht darüber hinaus in vorteilhafter Weise die Ausführung der Stromversorgung des elektronischen Geräts in zwei eigensicheren Stromkreisen, so daß die Vorschriften für den Explosionsschutz, die eine Begrenzung der Kapazität in einer Schaltung in Abhängigkeit von der an der Kapazität anliegenden Spannung vorschreiben, auf jeden einzelnen der beiden Stromkreise anwendbar sind und daher die Kapazitätsbegrenzung nicht für die Summenkapazität aller Stützkondensatoren gilt, sondern auf jeden einzelnen Stützkondensator beschränkt ist. Natürlich können innerhalb des elektronischen Geräts neben den beiden eigensicheren Stromkreisen weitere eigensichere Stromkreise für bestimmte Geräteteile vorgesehen werden.

Die Spannungsbegrenzung an den Stützkondensatoren erfolgt jeweils durch eine Zenerbarriere, die parallel zu dem betreffenden Stützkondensator liegt.

Zur weiteren Erläuterung der Erfindung wird im folgenden auf die Figuren der Zeichnung Bezug genommen; im einzelnen zeigen

Figur 1     ein Ausführungsbeispiel für das erfindungsgemäße elektronische Gerät und

Figur 2     ein Beispiel für den Strom- und Spannungsverlauf an dem Stützkondensator des nichtflüchtigen Speichers.

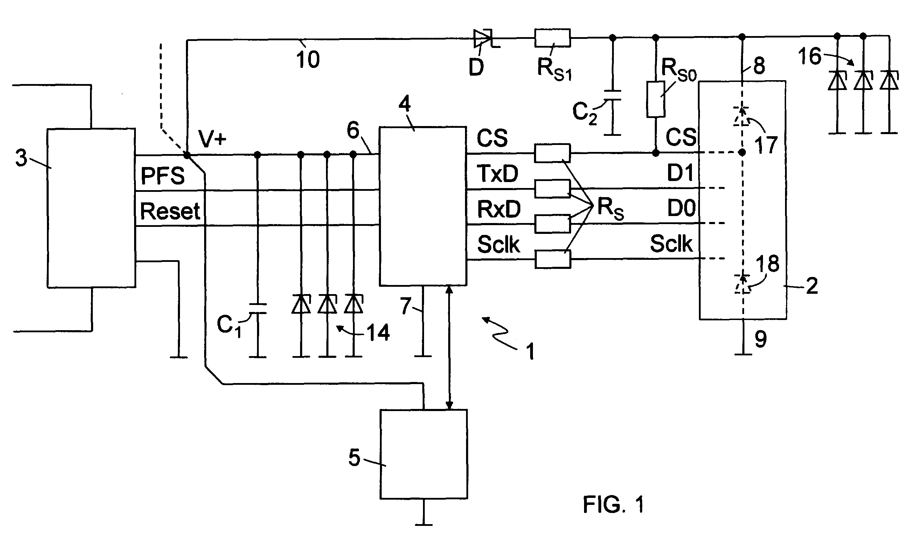

Figur 1 zeigt ein elektronisches Gerät mit einer Gerätesteuerung 1, einem nichtflüchtigen Speicher 2, hier einem EEPROM, und einer Stromversorgungseinrichtung 3. Die Gerätesteuerung 1 umfaßt hier einen Mikrocontroller 4 und einen Analog-/Digital-Umsetzer 5 sowie gegebenenfalls weitere, hier nicht gezeigte Geräteteile. Die Stromversorgungseinrichtung 3 stellt eine Versorgungsspannung V+ zur Verfügung, die den Versorgungsspannungsanschlüssen 6 und 7 bzw. 8 und 9 der Gerätesteuerung 1 und des nichtflüchtigen Speichers 2 zugeführt wird. Dabei liegt die Versorgungsspannung V+ unmittelbar an den Versorgungsspannungsanschlüssen 6 und 7 der Gerätesteuerung 1 an, während im Stromweg 10 zwischen dem Versorgungsspannungsanschluß 6 der Gerätesteuerung 1 und dem Versorgungsspannungsanschluß 8 des nichtflüchtigen Speichers 2 ein elektrisches Ventil D in Form einer Schottky-Diode und ein Strombegrenzungswiderstand $R_{S1}$ liegen. Zwischen den Versorgungsspannungsanschlüssen 6 und 7 der Gerätesteuerung 1 liegen ein Stützkondensator $C_1$ und eine dazu parallele Zenerbarriere 14, die ihrerseits aus drei parallelen Zenerdioden besteht. In gleicher Weise liegen zwischen den Versorgungsspannungsanschlüssen 8 und 9 des nichtflüchtigen Speichers 2 ein weiterer Stützkondensator $C_2$ und eine dazu parallele weitere Zenerbarriere 16. Die Stromversorgungseinrichtung 3 ist dazu ausgebildet, Einbrüche in der Versorgungsspannung V+ zu detektieren und diese als Power-Fail-Signal PFS dem Mikrocontroller 4 der Gerätesteuerung 1 mitzuteilen. Der Mikrocontroller 4 ist über eine Steuerleitung CS zum Aktivieren des nichtflüchtigen Speichers 2, eine erste Datenleitung TxD zum Übertragen von Daten zu dem nichtflüchtigen Speicher 2, eine weitere Datenleitung RxD zum Lesen von Daten aus dem nichtflüchtigen Speicher 2 und eine Taktleitung Sclk mit Ein- bzw. Ausgängen CS, D1, D0 bzw. Sclk des nichtflüchtigen Speichers 2 verbunden. Im Zuge jeder dieser Leitungen CS, TxD, RxD und Sclk ist jeweils ein Widerstand $R_S$ angeordnet. Wie am Beispiel des Eingangs CS gezeigt, ist jeder der Ein- bzw. Ausgänge CS, D1, D0, Sclk des nichtflüchtigen Speichers intern über Schutzdioden 17, 18 mit den Versorgungsspannungsanschlüssen 8 und 9 des nichtflüchtigen Speichers 2 verbunden. Zwischen dem Eingang CS zur Aktivierung des nichtflüchtigen Speichers 2 und seinem Versorgungsspannungsanschluß 8 ist ein Pull-Up-Widerstand $R_{S0}$ angeordnet.

Wenn die Stromversorgungseinrichtung 3 einen Einbruch der Versorgungsspannung V+ detektiert, veranlaßt sie den Mikrocontroller 4 durch das Power-Fail-Signal PFS dazu, vorgegebene Daten in Form eines oder mehrerer Datenpakete (Pages) über die Datenleitung TxD an den nichtflüchtigen Speicher 2 zu übertragen, wo sie von diesem selbständig abgespeichert werden. Die zur Durchführung dieser Datensicherung erforderliche Energie beziehen die Gerätesteuerung 1 und der nichtflüchtige Speicher 2 aus den ihnen jeweils zugeordneten Stützkondensatoren $C_1$ bzw. $C_2$. Der dem nichtflüchtigen Speicher 2 zugeordnete Stützkondensator $C_2$ wird über das elektrische Ventil D und den Strombegrenzungswiderstand $R_{S1}$ aus der Stromversorgungseinrichtung 3 geladen. Das elektrische Ventil D verhindert, daß im Falle eines Einbruchs der Versorgungsspannung V+ am Stützkondensator $C_1$ der Gerätesteuerung 1 der Stützkondensator $C_2$ des nichtflüchtigen Speichers 2 entladen wird. Der Strombegrenzungswiderstand $R_{S1}$ sorgt dafür, daß die Gerätesteuerung 1 nicht durch die Stromstöße des nichtflüchtigen Speichers 2 während des Speichervorgangs belastet wird. Während des Speichervorgangs sinkt die Spannung an den Versorgungsspannungsanschlüssen 8 und 9 des nichtflüchtigen Speichers 2 ab, wobei der Speichervorgang so lange nicht gefährdet ist, wie die Spannung einen Mindestwert überschreitet, der bei heutigen EEPROMs bei 1,8 V liegt. Die Widerstände $R_S$ in den Leitungen CS, TxD, RxD und Sclk zwischen dem Mikrocontroller 4 und dem nichtflüchtigen Speicher 2 verhindern, daß über die Schutzdioden 17, 18 des nichtflüchtigen Speichers 2 ein zu großer Ladestrom in den Stützkondensator $C_2$ fließt. Die Verzögerung durch diese Widerstände $R_S$ und die Kapazität der Leitungen kann im allgemeinen vernachlässigt werden, da die Datenübertragung meist mit Takten unter 2 MHz erfolgt. Der Pull-Up-Widerstand $R_{S0}$ verhindert, daß beim Ausfall der Stromversorgung für den nichtflüchtigen Speicher 2 Rauschen auf der Leitung CS zu einem ungewollten Speichervorgang führen kann. Während des Speichervorgangs ist die Stromentnahme aus dem Stützkondensator $C_2$ größer als der aus der Stromversorgungseinrichtung 3 über den Stromweg 10 und gegebenenfalls die Leitungen CS, TxD, RxD und Sclk fließende Ladestrom, der durch den Strombegrenzungswiderstand $R_{S1}$ und die Widerstände $R_S$ begrenzt ist. Im normalen Betrieb gewährleistet der Mikrocontroller 4, daß Speichervorgänge nicht unmittelbar hintereinander ausgeführt werden, so daß zwischenzeitlich der Stützkondensator $C_2$ wieder vollständig geladen werden kann.

Bei einem nichtflüchtigen Speicher 2 des Typs 25AA160 von Arizona Microchip liegt der Stromverbrauch zum Speichern eines Datenpakets bei maximal 2 mA über maximal 5 ms. Bei einer Versorgungsspannung V+ von 3,3 V kann aufgrund des Spannungsabfalls an dem elektrischen Ventil D von einer Spannung von 3 V an den Versorgungsspannungsanschlüssen 8, 9 des nichtflüchtigen Speichers 2 ausgegangen werden. Während des Speichervorgangs darf diese Spannung nicht unter den Mindestwert von 1,8 V abfallen. Unter Vernachlässigung des widerstandsbegrenzten Ladestroms muß daher der Stützkondensator $C_2$ mindestens eine Kapazität von

$$C_2 = I \cdot t/dU = 2 \text{ mA} \cdot 5 \text{ ms}/(3 \text{ V} - 1,8 \text{ V}) = 8,3 \text{ } \mu F$$

aufweisen.

Für die Übertragung der im Falle eines Einbruchs der Versorgungsspannung V+ abzusichernden Daten, z. B. Betriebsstundenzähler, zu dem nichtflüchtigen Speicher 2 muß die Gerätesteuerung 1 eine Zeit

$$t1 = n \cdot (tw + td) + ts$$

überbrücken können. Dabei bezeichnet n die Anzahl der Datenpakete (Pages), die in dem nichtflüchtigen Speicher 2 abgespeichert werden sollen, tw die Zeit für einen Speichervorgang, td die Zeit für die Übertragung der Daten von dem Mikrocontroller 4 zu dem nichtflüchtigen Speicher 2 und ts eine Sicherheitsreserve zur Kompensation von Temperaturschwankungen oder Alterungseffekten des nichtflüchtigen Speichers 2. Selbst wenn nur ein Datenpaket gesichert werden soll, muß angenommen werden, daß unmittelbar vor dem Einbruch der Versorgungsspannung V+ ein routinemäßiger Speichervorgang initiiert wurde, der erst abgeschlossen sein muß, bevor der nächste Speicherauftrag ausgeführt werden kann. Da bei einem Versorgungsspannungseinbruch meist nur wenige Daten gespeichert werden müssen, ist n meist Eins oder Zwei; die Übertragungszeit td ist gegenüber der Zeit tw für den Speichervorgang vernachlässigbar, so daß bei einer Sicherheitsreserve ts = 1 ms der Stützkondensator $C_1$ so dimensioniert werden muß, daß eine Überbrückungszeit von ca. (5 ms + 1 ms) = 6 ms für die Gerätesteuerung 1 sichergestellt ist. Wird für die Gerätesteuerung 1 ein Arbeitsbereich von 2,9 V bis 3,3 V angenommen und eine Stromaufnahme von 4 mA, dann ist bei einem widerstandsreduzierten Ladestrom des Stützkondensators $C_2$ von 0,2 mA eine Kapazität des Stützkondensators $C_1$ von

$$C_1 = (4\ mA + 0.2\ mA) \cdot 6\ ms/(3.3\ V - 2.9\ V) = 63\ \mu F$$

erforderlich.

Da der Stützkondensator $C_2$ des nichtflüchtigen Speichers 2 aufgrund des Strombegrenzungswiderstands $R_{S1}$ nur vergleichsweise langsam aufgeladen wird und, wie oben erwähnt, in Verbindung mit einem Versorgungsspannungseinbruch zwei Speichervorgänge unmittelbar aufeinander folgen können, muß der für den Stützkondensator $C_2$ des nichtflüchtigen Speichers 2 oben angegebene Kapazitätswert von 8,3 μF auf 16,6 μF verdoppelt werden.

Die Vorschriften für den Explosionsschutz schreiben eine Begrenzung der Kapazität in einer Schaltung in Abhängigkeit von der Spannung auf 100 μF bei 5 V vor. Bei dem hier gezeigten Ausführungsbeispiel sind die Stromversorgungskreise für die Gerätesteuerung 1 und den nichtflüchtigen Speicher 2 durch das elektrische Ventil D und die Widerstände $R_{S1}$ und $R_S$ derart voneinander entkoppelt, daß die genannten Vorschriften auf jeden einzelnen der beiden Stromversorgungskreise getrennt angewendet werden können. Mit den oben angegebenen Beispielswerten von 63 μF für den Stützkondensator $C_1$ und 16,6 μF für den Stützkondensator $C_2$ werden diese Vorgaben des Explosionsschutzes einfach erfüllt. Auf gleiche Weise können weitere, hier nicht gezeigte Geräteteile aus weiteren entkoppelten, eigensicheren Stromversorgungskreisen versorgt werden.

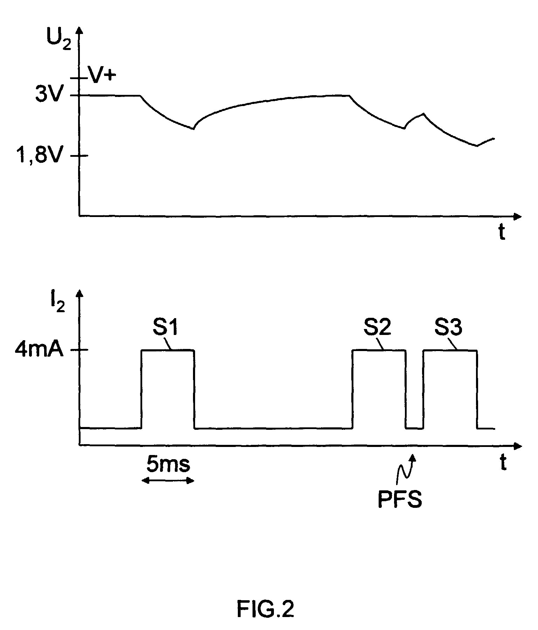

Figur 2 zeigt ein Beispiel für den Verlauf der Spannung $U_2$ an den Versorgungsspannungsanschlüssen 8 und 9 des nichtflüchtigen Speichers 2 und dessen Stromaufnahme $I_2$. Bei routinemäßigen Speichervorgängen S1 und S2 wird der Stützkondensator $C_2$ für jeweils 5 ms mit 2 mA entladen. Der Mikrocontroller 4 gewährleistet einen zeitlichen Mindestabstand zwischen den Speichervorgängen S1 und S2, in dem der Stützkondensator $C_2$ wieder vollständig aufgeladen wird. Das Power-Fail-Signal PFS teilt dem Mikrocontroller 4 einen Versorgungsspannungseinbruch mit, der ungünstigstenfalls unmittelbar nach einem routinemäßigen Speichervorgang, hier S2, auftritt. In der Folge wird in einem weiteren Speichervorgang S3 eine Datensicherung vorgenommen. Der Stützkondensator $C_2$ ist so bemessen, daß die Spannung $U_2$ nicht unter den Minimalwert von 1,8 V fällt.

**Patentansprüche**

1. Elektronisches Gerät, insbesondere Feldgerät, mit einer datenverarbeitenden Gerätesteuerung (1), mit einem nichtflüchtigen Speicher (2), in dem über eine Datenleitung (TxD) ein aus ausgewählten Daten der Gerätesteuerung (1) bestehendes Datenpaket übertragbar und dort abspeicherbar ist, und mit einer Stromversorgungseinrichtung (3), die eine Versorgungsspannung (V+) für die Gerätesteuerung (1) und den nichtflüchtigen Speicher (2) bereitstellt und bei einem Versorgungsspannungseinbruch die Gerätesteuerung (1) zur Übertragung mindestens eines aktuellen Datenpakets zu dem nichtflüchtigen Speicher (2) ansteuert, wobei sowohl zwischen den Versorgungsspannungsanschlüssen (6, 7) der Gerätesteuerung (1) als auch zwischen den Versorgungsspannungsanschlüssen (8, 9) des nichtflüchtigen Speichers (2) jeweils ein Stützkondensator ($C_1$, $C_2$) liegt und im Stromweg (10) zwischen beiden Stützkondensatoren ($C_1$, $C_2$) ein Strombegrenzungswiderstand ($R_{S1}$) und ein eine Entladung des dem nichtflüchtigen Speicher (2) zugeordneten Stützkondensators ($C_2$) verhinderndes elektrisches Ventil (D) angeordnet sind.

2. Elektronisches Gerät nach Anspruch 1, dadurch gekennzeichnet, daß bei einem nichtflüchtigen Speicher (2), dessen Ein- und Ausgänge (CS, D1, D0, Sclk) über interne Schutzdioden (17, 18) mit den Versorgungsspannungsanschlüssen (8, 9) verbunden sind, Widerstände ($R_S$) in der Datenleitung (TxD) und gegebenenfalls weiteren Leitungen (CS, RxD, Sclk) zwischen der Gerätesteuerung (1) und dem nichtflüchtigen Speicher (2) angeordnet sind.

3. Elektronisches Gerät nach Anspruch 1 oder 2, dadurch gekennzeichnet, daß parallel zu dem Stützkondensator ($C_1$, $C_2$) eine Zenerbarriere (14, 16) liegt.

FIG. 1

EP 1 049 099 A2

FIG.2